(19) Europäisches Patentamt
European Patent Office
Office européen des brevets

(11) EP 4 383 327 A1

(12) EUROPEAN PATENT APPLICATION
published in accordance with Art. 153(4) EPC

(43) Date of publication:
**12.06.2024 Bulletin 2024/24**

(21) Application number: **21952689.4**

(22) Date of filing: **02.08.2021**

(51) International Patent Classification (IPC):
***H01L 23/373** (2006.01)* ***C04B 35/5835** (2006.01)*

(52) Cooperative Patent Classification (CPC):
**C09K 5/14; C04B 35/5831; C04B 35/6261; C04B 35/645; C22C 26/00; H01L 23/36; H01L 23/373;** C04B 2235/386; C04B 2235/402; C04B 2235/425; C04B 2235/427; C04B 2235/428; C04B 2235/5436; C04B 2235/5445; C04B 2235/5463; (Cont.)

(86) International application number:
**PCT/JP2021/028575**

(87) International publication number:
**WO 2023/012858 (09.02.2023 Gazette 2023/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
- **Sumitomo Electric Hardmetal Corp.**
  **Itami-shi, Hyogo 664-0016 (JP)**
- **SUMITOMO ELECTRIC INDUSTRIES, LTD.**
  **Osaka-shi, Osaka 541-0041 (JP)**

(72) Inventors:
- **ISHIDA, Yuh**
  **Itami-shi, Hyogo 664-0016 (JP)**
- **KUKINO, Satoru**
  **Osaka-shi, Osaka 541-0041 (JP)**

(74) Representative: **Boult Wade Tennant LLP**
**Salisbury Square House**
**8 Salisbury Square**
**London EC4Y 8AP (GB)**

# (54) CUBIC BORON NITRIDE SINTERED COMPACT AND HEAT SINK USING SAME

(57) A cubic boron nitride sintered material comprising 90.0% by mass or more and 99.5% by mass or less of cubic boron nitride and 0.5% by mass or more and 10.0% by mass or less of silicon, wherein the cubic boron nitride sintered material has a total content of the cubic boron nitride and the silicon of 94.0% by mass or more and 100% by mass or less.

EP 4 383 327 A1

(52) Cooperative Patent Classification (CPC): (Cont.)
C04B 2235/6567; C04B 2235/6581;
C04B 2235/661; C04B 2235/77; C04B 2235/782;
C04B 2235/786; C04B 2235/80; C04B 2235/96;
C04B 2235/9607; C22C 2026/003

## Description

TECHNICAL FIELD

The present disclosure relates to a cubic boron nitride sintered material and a heatsink using the same.

BACKGROUND ART

Demands for solar power generation, wind power generation, electric cars, and the like have been expanded in order to reduce greenhouse gases as global environmental issues. Power semiconductors are used therefor. Materials for power semiconductors are being shifted from currently major silicon (Si) toward higher-performance silicon carbide (SiC) and gallium nitride (GaN). In such power semiconductors, a technique is adopted in which heat is diffused by using a heatsink.

Cubic boron nitride (hereinafter, also referred to as "cBN".) has a heat conductivity that is second only to diamond. In addition, cubic boron nitride has a heat expansion coefficient close to that of a power semiconductor, and furthermore is an insulating material. Therefore, cubic boron nitride is suitable for a heatsink material.

SUMMARY OF INVENTION

The present disclosure relates to a cubic boron nitride sintered material comprising 90.0% by mass or more and 99.5% by mass or less of cubic boron nitride and 0.5% by mass or more and 10.0% by mass or less of silicon, wherein the cubic boron nitride sintered material has a total content of the cubic boron nitride and the silicon of 94.0% by mass or more and 100% by mass or less.

The present disclosure relates to a heatsink using the above cubic boron nitride sintered material.

DETAILED DESCRIPTION

[Problem to be Solved by the Present Disclosure]

A cubic boron nitride sintered material obtained by sintering cubic boron nitride particles with a binder has been conventionally used in the case of an application of cubic boron nitride to a heatsink. However, the binder has highly caused a reduction in heat conductivity.

Accordingly, an object of the present disclosure is to provide a cubic boron nitride sintered material having high heat conductivity and a heat expansion coefficient close to that of a power semiconductor, and a heatsink having high heat conductivity and a heat expansion coefficient close to that of a power semiconductor.

[Advantageous Effect of the Present Disclosure]

According to the present disclosure, it is possible to provide a cubic boron nitride sintered material having high heat conductivity and a heat expansion coefficient close to that of a power semiconductor, and a heatsink having high heat conductivity and a heat expansion coefficient close to that of a power semiconductor.

[Description of Embodiments]

First, the embodiments of the present disclosure will be listed and described.

(1) The present disclosure relates to a cubic boron nitride sintered material comprising 90.0% by mass or more and 99.5% by mass or less of cubic boron nitride and 0.5% by mass or more and 10.0% by mass or less of silicon, wherein

the cubic boron nitride sintered material has a total content of the cubic boron nitride and the silicon of 94.0% by mass or more and 100% by mass or less.
According to the present disclosure, it is possible to provide a cubic boron nitride sintered material having high heat conductivity and a heat expansion coefficient close to that of a power semiconductor.

(2) It is preferable that the cubic boron nitride sintered material comprises carbon and has a carbon content of 0.10% by mass or more and 5.00% by mass or less. According to this, the cubic boron nitride sintered material has higher heat conductivity, and can have a heat expansion coefficient close to the heat expansion coefficient of a power semiconductor.

(3) At least a portion of the carbon is preferably diamond. According to this, the cubic boron nitride sintered material has higher heat conductivity, and can have a heat expansion coefficient close to the heat expansion coefficient of a power semiconductor.

(4) It is preferable that the cubic boron nitride sintered material comprises aluminum and has an aluminum content of 0.01% by mass or more and 5.00% by mass or less. According to this, the cubic boron nitride sintered material has higher heat conductivity.

(5) It is preferable that the cubic boron nitride sintered material comprises a plurality of crystal grains composed of cubic boron nitride and the crystal grains have a median diameter d50 of an equivalent circle diameter of 1.0 μm or more. According to this, the cubic boron nitride sintered material has higher heat conductivity.

(6) The cubic boron nitride sintered material preferably has a heat conductivity of 300 W/mK or more. By having such a heat conductivity, the cubic boron nitride sintered material has high heat conductivity.

(7) The cubic boron nitride sintered material preferably has a heat expansion coefficient of $4.0 \times 10^{-6}$/K or more and $6.0 \times 10^{-6}$/K or less. By having such a heat expansion coefficient, the cubic boron nitride sintered material has a heat expansion coefficient close to that of a power semiconductor.

(8) The cubic boron nitride preferably has a dislocation density of $1 \times 10^{16}/m^2$ or less. By having such a dislocation density, the cubic boron nitride sintered material has higher heat conductivity.

(9) It is preferable that the dislocation density be calculated by using a modified Williamson-Hall method and a modified Warren-Averbach method.

(10) It is preferable that the dislocation density be measured using synchrotron radiation as an X-ray source.

(11) The present disclosure relates to a heatsink using the above cubic boron nitride sintered material. According to the present disclosure, it is possible to provide a heatsink having high heat conductivity and a heat expansion coefficient close to that of a power semiconductor.

[Details of embodiments of present disclosure]

Specific examples of the cubic boron nitride sintered material and the heatsink of the present disclosure will be described below.

In the present specification, the designation "A to B" means to include the upper limit and the lower limit of a range (namely, A or more and B or less), and when no unit is designated with A and any unit is designated with only B, the unit of A and the unit ofB are the same as each other.

In the present specification, the power semiconductor means a semiconductor including silicon carbide (SiC) or gallium nitride (GaN) as a material. SiC has a heat expansion coefficient of 4.0 to $5.0 \times 10^{-6}$/K, and GaN has a heat expansion coefficient of 5.5 to $6.0 \times 10^{-6}$/K. Therefore, in the present specification, the heat expansion coefficient of the power semiconductor means 4.0 to $6.0 \times 10^{-6}$/K.

[First Embodiment: cubic boron nitride sintered material]

One embodiment of the present disclosure (hereinafter, also referred to as "the present embodiment".) relates to a cubic boron nitride sintered material comprising 90.0% by mass or more and 99.5% by mass or less of cubic boron nitride and 0.5% by mass or more and 10.0% by mass or less of silicon, wherein
the cubic boron nitride sintered material has a total content of the cubic boron nitride and the silicon of 94.0% by mass or more and 100% by mass or less.

The cubic boron nitride sintered material of the present embodiment can have high heat conductivity and a heat expansion coefficient close to that of the power semiconductor. The reason for this is presumed to be as described in the following (i) to (iv).

(i) The cubic boron nitride sintered material of the present embodiment includes 90.0% by mass or more and 99.5% by mass or less of a cubic boron nitride having high heat conductivity. Therefore, the cubic boron nitride sintered material can have high heat conductivity.

(ii) The cubic boron nitride sintered material of the present embodiment has a total content of a cubic boron nitride (heat expansion coefficient: about 3.0 to $4.0 \times 10^{-6}$/K) having a heat expansion coefficient close to the heat expansion coefficient of the power semiconductor (about 4.0 to $6.0 \times 10^{-6}$/K) and silicon (heat expansion coefficient: about $4.0 \times 10^{-6}$/K), of 94.0% by mass or more and 100% by mass or less. Therefore, the cubic boron nitride sintered material can have a heat expansion coefficient close to that of the power semiconductor.

(iii) The silicon included in the cubic boron nitride sintered material of the present embodiment may partially react with carbon in the cubic boron nitride to thereby form silicon carbide (SiC). Silicon carbide is a substance excellent in oxidation resistance, and thus, if silicon carbide is present between cubic boron nitride particles or in the vicinity thereof, oxygen as an unavoidable impurity does not penetrate between cubic boron nitride particles and formation of an oxide inhibiting bonding between cubic boron nitride particles is suppressed. Therefore, the bonding force between cubic boron nitride particles is increased, and the cubic boron nitride sintered material can have high heat conductivity. The silicon carbide has a heat expansion coefficient identical to or close to the heat expansion coefficient of the power semiconductor. Therefore, the cubic boron nitride sintered material can have a heat expansion coefficient close to that of the power semiconductor. The cubic boron nitride sintered material of the present embodiment may or may not include silicon carbide as long as the effects thereof are exerted.

(iv) When oxygen as an unavoidable impurity is present in the surfaces of cubic boron nitride particles, namely, between cubic boron nitride particles in the cubic boron nitride sintered material, the bonding force between cubic boron nitride particles tends to be decreased. The silicon included in the cubic boron nitride in the present embodiment may partially react with the oxygen to thereby form silicon oxide ($SiO_2$). In this case, oxygen present in the surfaces of cubic boron nitride particles, namely, between cubic boron nitride particles is decreased, the bonding force between cubic boron nitride particles is inhibited from being decreased and the cubic boron nitride sintered material has higher heat conductivity. The cubic boron nitride sintered material of the present embodiment may or may not include silicon oxide as long as the effects thereof are exerted.

<Composition>

The cubic boron nitride sintered material of the present embodiment includes 90.0% by mass or more and 99.5% by mass or less of cubic boron nitride and 0.5% by mass or more and 10.0% by mass or less of silicon, and has a total content of the cubic boron nitride and the silicon of 94.0% by mass or more and 100% by mass or less.

The cubic boron nitride sintered material of the present embodiment can include unavoidable impurities due to raw materials used, manufacturing conditions, and the like. The content (% by mass) of the unavoidable impurities in the cubic boron nitride sintered material is preferably 0% by mass or more and 1% by mass or less, and further preferably 0% by mass or more and 0.1% by mass or less. The cubic boron nitride sintered material of the present embodiment can include cubic boron nitride particles, silicon, and unavoidable impurities. The cubic boron nitride sintered material of the present embodiment can consist of cubic boron nitride particles, silicon, carbon, and unavoidable impurities. The cubic boron nitride sintered material of the present embodiment can consist of cubic boron nitride particles, silicon, aluminum, and unavoidable impurities. The cubic boron nitride sintered material of the present embodiment can consist of cubic boron nitride particles, silicon, carbon, aluminum, and unavoidable impurities.

<Cubic boron nitride content>

The lower limit of the cubic boron nitride content of the cubic boron nitride sintered material is 90.0% by mass or more, preferably 91.0% by mass or more, more preferably 92.0% by mass or more, and further preferably 93.0% by mass or more. The upper limit of the cubic boron nitride content in the cubic boron nitride sintered material is 99.5% by mass or less, preferably 99.0% by mass or less, more preferably 98.0% by mass or less, and further preferably 97.0% by mass or less. The cubic boron nitride content in the cubic boron nitride sintered material is 90.0% by mass or more and 99.5% by mass or less, preferably 91.0% by mass or more and 99.0% by mass or less, more preferably 92.0% by mass or more and 98.0% by mass or less, and further preferably 93.0% by mass or more and 97.0% by mass or less.

The cubic boron nitride content (% by mass) in the cubic boron nitride sintered material is measured by the following methods (A1) to (F1). The following methods can be used by use of an energy dispersive X-ray analyzer (EDX) (X-MAX80 EDS system manufactured by Oxford Instruments) attached to a scanning electron microscope (SEM) ("JSM-7800F" (trade name) manufactured by JEOL Ltd.) (hereinafter, also referred to as "SEM-EDX".).

(A1) The cubic boron nitride sintered material is cut at any position, and a sample including a cross section of the cubic boron nitride sintered material is produced. The cross section is produced by use of a focused ion beam apparatus, a cross section polisher apparatus or the like.

(B1) The above cross section is observed with SEM at a magnification of 5000 times, and a backscattered electron image is obtained. A black region in the backscattered electron image is a region where the cubic boron nitride is present. A gray region and a white region are regions where components (silicon, carbon, aluminum, unavoidable impurities, and the like) other than the cubic boron nitride are present. The presence of the cubic boron nitride in the black region and the presence of such components other than the cubic boron nitride in the in the gray region and the white region in the backscattered electron image can be confirmed by performing elemental analysis with SEM-EDX of the same observation region as the backscattered electron image of the cubic boron nitride sintered material.

(C1) Next, the backscattered electron image is subjected to binarization processing by use of image analysis software ("WinROOF" manufactured by Mitani Corporation). In the binarization processing, the image contrast value is divided into 256 (low contrast: 0, high contrast: 255) in taking of the backscattered electron image, and the contrast value of the region where the cubic boron nitride is present, specified as described above, is set so as to be below 30. Thus, the region where the cubic boron nitride is present can be extracted.

(D1) A measurement region of 12 μm × 9 μm is set in an image after the binarization processing. The area ratio of the region where the cubic boron nitride is present in the measurement region is calculated. The area ratio calculated is regarded in terms of "% by volume", and thus the cubic boron nitride content (% by volume) of the cubic boron nitride sintered material can be determined. If the threshold value is set in the binarization processing, no variation in cubic boron nitride content in the cubic boron nitride sintered material is caused as long as measurement is made in the same visual field.

(E1) The density $\rho_1$ of the above cubic boron nitride sintered material is measured by means of the Archimedes' principle. The density ρ1 of the cubic boron nitride sintered material is represented by the following expression.

$$\rho_1 = M \times (\rho_0 - d)/(A - B) + d$$

In the above expression, $\rho_1$ represents the density ($g/cm^3$) of the cubic boron nitride sintered material, A represents the weight (g) of the cubic boron nitride sintered material in the air, B represents the weight (g) of the cubic boron nitride sintered material in the liquid, $\rho_0$ represents the density ($g/cm^3$) of the liquid, and d represents the density ($0.001 g/cm^3$) of the air.

(F1) The cubic boron nitride content (% by mass) in the cubic boron nitride sintered material is determined based on the cubic boron nitride content q (% by volume) in the cubic boron nitride sintered material, the density $\rho_2$ ($g/cm^3$, specifically 3.45 $g/cm^3$) of the cubic boron nitride, and the density $\rho_1$ ($g/cm^3$) of the cubic boron nitride sintered material, as measured as described above. The cubic boron nitride content (% by mass) in the cubic boron nitride sintered material is represented by the following expression.

Cubic boron nitride content (% by mass) in cubic boron nitride sintered material = $q \times p_2/p_1$

<Silicon content>

The silicon content in the cubic boron nitride sintered material is 0.5% by mass or more and 10.0% by mass or less. According to this, the cubic boron nitride sintered material can have a heat expansion coefficient close to that of the power semiconductor. The bonding force between cBN particles is increased, and the cubic boron nitride sintered material can have high heat conductivity.

The silicon present in the cubic boron nitride sintered material may be a silicon simple substance, or may be a silicon compound generated by a reaction of silicon with other element included in the cubic boron nitride sintered material. Even in the case of a silicon simple substance, an element such as boron, as a simple substance, may be present in silicon. Examples of the silicon compound include silicon boride ($SiB_6$), silicon nitride (SiN), silicon oxide ($SiO_2$), and silicon carbide (SiC). Silicon is high in raw material cost, and has not been used at a content of 0.5% by mass or more in a conventional cubic boron nitride sintered material.

The lower limit of the silicon content in the cubic boron nitride sintered material of the present embodiment is 0.5% by mass or more, preferably 1.0% by mass or more, more preferably 2.0% by mass or more, and further preferably 3.0% by mass or more. The upper limit of the silicon content in the cubic boron nitride sintered material is 10.0% by mass or less, preferably 9.0% by mass or less, more preferably 8.0% by mass or less, and further preferably 7.0% by mass or less. The silicon content in the cubic boron nitride sintered material is 0.5% by mass or more and 10.0% by mass or less, preferably 1.0% by mass or more and 9.0% by mass or less, more preferably 2.0% by mass or more and 8.0% by mass or less, and further preferably 3.0% by mass or more and 7.0% by mass or less.

The silicon content in the cubic boron nitride sintered material is measured by use of an electron probe micro analyzer (EPMA). A measurement installation and a measurement condition are as follows.

Installation: JXA-8530F manufactured by JEOL Ltd.
Measurement condition: acceleration voltage 15 kV

<Carbon content>

The cubic boron nitride sintered material of the present embodiment includes carbon, and the carbon content is preferably 0.10% by mass or more and 5.00% by mass or less. The carbon included in the cubic boron nitride sintered material may partially react with silicon to thereby form silicon carbide (SiC). Silicon carbide is a substance excellent in oxidation resistance, and thus, if silicon carbide is present between cubic boron nitride particles or in the vicinity thereof, oxygen as an unavoidable impurity does not penetrate between cubic boron nitride particles and formation of an oxide inhibiting bonding between cubic boron nitride particles is suppressed. When the cubic boron nitride sintered material contains the carbon in the above range, the bonding force between cubic boron nitride particles is increased, and the cubic boron nitride sintered material can have high heat conductivity. The SiC has a heat expansion coefficient identical to or close to the heat expansion coefficient of the power semiconductor. Therefore, the cubic boron nitride sintered material can have a heat expansion coefficient close to that of the power semiconductor.

The lower limit of the carbon content in the cubic boron nitride sintered material is preferably 0.10% by mass or more, more preferably 1.00% by mass or more, and further preferably 2.00% by mass or more. The upper limit of the carbon content in the cubic boron nitride sintered material is preferably 5.00% by mass or less, more preferably 4.50% by mass or less, and further preferably 4.00% by mass or less. The carbon content in the cubic boron nitride sintered material is preferably 0.10% by mass or more and 5.00% by mass or less, more preferably 1.00% by mass or more and 4.50% by mass or less, and further preferably 2.00% by mass or more and 4.00% by mass or less.

At least a portion of the carbon is preferably diamond. According to this, the cubic boron nitride sintered material has higher heat conductivity, and can have a heat expansion coefficient close to the heat expansion coefficient of the power semiconductor. The carbon may be partially diamond or may be fully diamond.

The median diameter d50 of an equivalent circle diameter of the diamond in the cubic boron nitride in the present embodiment (hereinafter, also referred to as "d50 of an equivalent circle diameter".) is preferably 1.0 μm or more. According to this, the cubic boron nitride sintered material has higher heat conductivity. In the present specification, the median diameter d50 of an equivalent circle diameter means an equivalent circle diameter where the cumulative of frequency based on the number reaches 50%.

The lower limit of the d50 of an equivalent circle diameter of the diamond is preferably 1.0 μm or more, preferably 2.0 μm or more, preferably 3.0 μm or more, preferably 5.0 μm or more, preferably 7.0 μm or more, and preferably 8.0 μm or more. As the d50 of an equivalent circle diameter of the diamond is increased, heat conductivity is high, and the d50 is not particularly limited and can be set to 100 μm or less from a production viewpoint. The d50 of an equivalent circle diameter of the diamond is preferably 1.0 μm or more and 100 μm or less, preferably 2.0 μm or more and 100 μm or less, preferably 3.0 μm or more and 100 μm or less, preferably 5.0 μm or more and 100 μm or less, preferably 7.0 μm or more and 100 μm or less, and preferably 8.0 μm or more and 100 μm or less.

In the present specification, the d50 of an equivalent circle diameter of the diamond included in the cubic boron nitride is measured by the following procedure.

An image of the cubic boron nitride sintered material after binarization processing is obtained by the same methods as the measurement methods (A1) to (C1) of the cubic boron nitride content (% by mass) in the cubic boron nitride sintered material.

A measurement visual field of 12 μm × 9 μm is set in the image after binarization processing. The distribution of the equivalent circle diameter of the diamond is measured using the image processing software in a state in which the grain boundaries of the diamond observed in the measurement visual field are isolated. Any five such measurement visual fields are set.

The d50 of an equivalent circle diameter of the diamond is determined with the number of the diamond in the entire of such each measurement visual field, as the denominator, based on the above distribution of the equivalent circle diameter of the diamond. In each of the five measurement visual fields, each d50 of an equivalent circle diameter of the diamond is determined and the average value thereof is calculated. The average value corresponds to the d50 of an equivalent circle diameter of the diamond included in the cubic boron nitride.

To the extent measured by the applicant, it has been confirmed that as long as the d50 of an equivalent circle diameter of the diamond is measured in the same sample, even the calculation is performed a plurality of times by changing the selected locations for the measurement visual field in the cubic boron nitride sintered material, there is almost no variation in the measurement results and there is no arbitrariness even when the measurement visual field is randomly set.

<Aluminum content>

The cubic boron nitride sintered material of the present embodiment includes aluminum, and the aluminum content is preferably 0.01% by mass or more and 5.00% by mass or less. When oxygen as an unavoidable impurity is present in the surfaces of cubic boron nitride particles, namely, between cubic boron nitride particles in the cubic boron nitride sintered material, the bonding force between cubic boron nitride particles tends to be decreased. When the cubic boron nitride includes aluminum, the aluminum may partially bond to the above oxygen to thereby form aluminum oxide ($Al_2O_3$). In this case, oxygen present in the surfaces of cubic boron nitride particles, namely, between cubic boron nitride particles is decreased, the bonding force between cubic boron nitride particles is inhibited from being decreased and the cubic boron nitride sintered material has higher heat conductivity.

The aluminum included in the cubic boron nitride sintered material may partially react with nitrogen and/or silicon included in the cubic boron nitride sintered material to thereby form aluminum nitride (AlN) and/or aluminum silicon carbide ($Al_4SiC_4$). Aluminum nitride and aluminum silicon carbide are substances excellent in oxidation resistance, and thus, if aluminum nitride and aluminum silicon carbide are present between cubic boron nitride particles or in the vicinity thereof, oxygen as an unavoidable impurity does not penetrate between cubic boron nitride particles and formation of an oxide inhibiting bonding between cubic boron nitride particles is suppressed. Therefore, the bonding force between cubic boron nitride particles is increased, and the cubic boron nitride sintered material can have high heat conductivity.
The aluminum included in the cubic boron nitride sintered material may also partially react with boron included in the cubic boron nitride sintered material to thereby form aluminum boride ($AlB_2$, $AlB_{12}$).

<Unavoidable impurities>

The cubic boron nitride sintered material of the present disclosure can include unavoidable impurities within a range in which the effects of the present disclosure are exhibited. Examples of unavoidable impurities include hydrogen, oxygen, lithium (Li), sodium (Na), potassium (K), calcium (Ca), and magnesium (Mg). The content of the unavoidable impurities in the cubic boron nitride sintered material is preferably 0% by mass or more and 1% by mass or less, and further preferably 0% by mass or more and 0.1% by mass or less. The content of the unavoidable impurities can be measured by secondary ion mass spectrometry (SIMS).

<d50 and d90 of equivalent circle diameters of crystal grains>

In the cubic boron nitride sintered material of the present embodiment, the cubic boron nitride sintered material includes a plurality of crystal grains composed of cubic boron nitride, and the crystal grains preferably have a median diameter d50 of an equivalent circle diameter (hereinafter, also referred to as "d50 of an equivalent circle diameter".) of 1.0 μm or more. According to this, the cubic boron nitride sintered material has higher heat conductivity. In the present specification, the median diameter d50 of an equivalent circle diameter of the crystal grains means an equivalent circle diameter where the cumulative of frequency based on the number reaches 50%.
The lower limit of the d50 of an equivalent circle diameter of the crystal grains is preferably 1.0 μm or more, preferably 2.0 μm or more, preferably 3.0 μm or more, preferably 5.0 μm or more, preferably 7.0 μm or more, and preferably 8.0 μm or more. As the d50 of an equivalent circle diameter of the crystal grains is increased, heat conductivity is high, and thus the d50 is not particularly limited and can be set to 100 μm or less from a production viewpoint. The d50 of an equivalent circle diameter of the crystal grains is preferably 1.0 μm or more and 100 μm or less, preferably 2.0 μm or more and 100 μm or less, preferably 3.0 μm or more and 100 μm or less, preferably 5.0 μm or more and 100 μm or less, preferably 7.0 μm or more and 100 μm or less, and preferably 8.0 μm or more and 100 μm or less.
In the cubic boron nitride sintered material of the present embodiment, the cubic boron nitride is composed of a plurality of crystal grains, and the d90 of an equivalent circle diameter of the crystal grains is preferably 1.2 μm or more. According to this, the cubic boron nitride sintered material has higher heat conductivity. In the present specification, the d90 of an equivalent circle diameter of the crystal grains means an equivalent circle diameter where the cumulative of frequency based on the number reaches 90%.
The lower limit of the d90 of an equivalent circle diameter of the crystal grains is preferably 1.2 μm or more, and preferably 3.6 μm or more. As the d90 of an equivalent circle diameter of the crystal grains is increased, heat conductivity is high, and the d90 is not particularly limited and can be set to 150 μm or less from a production viewpoint. The d90 of an equivalent circle diameter of the crystal grains is preferably 1.2 μm or more and 150 μm or less and more preferably 3.6 μm or more and 150 μm or less.
In the present specification, the d50 and d90 of equivalent circle diameters of the plurality of crystal grains included in the cubic boron nitride are measured by the following procedure.
An image of the cubic boron nitride sintered material after binarization processing is obtained by the same methods as the measurement methods (A1) to (C1) of the cubic boron nitride content (% by mass) in the cubic boron nitride sintered material.
A measurement visual field of 12 μm × 9 μm is set in the image after binarization processing. The distribution of the equivalent circle diameters of the crystal grains is measured using the image processing software in a state in which the grain boundaries of the crystal grains composed of cubic boron nitride observed in the measurement visual field are isolated. Any five such measurement visual fields are set.
The d50 of an equivalent circle diameter of the crystal grains is determined with the number of the crystal grains in the entire of such each measurement visual field, as the denominator, based on the above distribution of the equivalent circle diameters of the crystal grains. In each of the five measurement visual fields, each d50 of an equivalent circle diameter of the crystal grains is determined and the average value thereof is calculated. The average value corresponds to the d50 of an equivalent circle diameter of the plurality of crystal grains included in the cubic boron nitride.

The d90 of an equivalent circle diameter of the crystal grains is determined with the number of the crystal grains in the entire of such each measurement visual field, as the denominator, based on the above distribution of the equivalent circle diameters of the crystal grains. In each of the five measurement visual fields, each d90 of an equivalent circle diameter of the crystal grains is determined and the average value thereof is calculated. The average value corresponds to the d90 of an equivalent circle diameter of the plurality of crystal grains included in the cubic boron nitride sintered material.

To the extent measured by the applicant, it has been confirmed that as long as the d50 and d90 of equivalent circle diameters of the crystal grains are measured in the same sample, even the calculation is performed a plurality of times by changing the selected locations for the measurement visual field in the cubic boron nitride sintered material, there is almost no variation in the measurement results and there is no arbitrariness even when the measurement visual field is randomly set.

The crystal grains composed of cubic boron nitride may be composed of pure cubic boron nitride including no impurity element, or can also include unavoidable impurities in addition to such cubic boron nitride within a range in which the effects of the present disclosure are exhibited. The content of the unavoidable impurities in the crystal grains is preferably 0% by mass or more and 0.1% by mass or less. The content of the unavoidable impurities is measured by ICP (Inductively Coupled Plasma) Emission Spectroscopy (measurement equipment: Shimadzu Corporation "ICPS-8100" (TM)).

<Heat conductivity>

The lower limit of the heat conductivity of the cubic boron nitride sintered material of the present embodiment is preferably 290 W or more, preferably 300 W/mK or more, more preferably 400 W/mK or more, and further preferably 500 W/mK or more. Although the upper limit of the heat conductivity of the cubic boron nitride sintered material is not particularly limited, it can be set to, for example, 2000 W/mK or less. The heat conductivity of the cubic boron nitride sintered material is preferably 290 W/mK or more and 2000 W/mK or less, preferably 300 W/mK or more and 2000 W/mK or less, more preferably 400 W/mK or more and 2000 W/mK or less, and further preferably 500 W/mK or more and 2000 W/mK or less.

In the present specification, the heat conductivity of the cubic boron nitride sintered material is obtained by measuring thermal diffusivity by a laser flash method using a xenon flash lamp, and converting the thermal diffusivity into the heat conductivity. The measurement temperature is 25°C. "LFA467 Hyper Flash" (TM) manufactured by NETZSCH Japan can be used for the measurement equipment. The following conditions (a) to (c) are adopted in the above conversion.

(a)

$$\text{Heat conductivity} = \text{thermal diffusivity} \times \text{specific heat} \times \text{density}$$

(b) Cubic boron nitride has a density of 3.45 g/cm$^3$ and a specific heat of 0.6 J/mol

(c) The cubic boron nitride content in the cubic boron nitride sintered material is assumed to be 100% by mass.

<Heat expansion coefficient>

The cubic boron nitride sintered material of the present embodiment preferably has a heat expansion coefficient of $4.0 \times 10^{-6}$/K or more and $6.0 \times 10^{-6}$/K or less. According to this, the cubic boron nitride sintered material can have a heat expansion coefficient close to that of the power semiconductor.

The lower limit of heat expansion coefficient of the cubic boron nitride sintered material of the present embodiment is preferably $4.0 \times 10^{-6}$/K or more, more preferably $4.3 \times 10^{-6}$/K or more, and further preferably $4.5 \times 10^{-6}$/K or more. The upper limit of the heat expansion coefficient of the cubic boron nitride sintered material is preferably $6.0 \times 10^{-6}$/K or less, more preferably $5.8 \times 10^{-6}$/K or less, and further preferably $5.5 \times 10^{-6}$/K or less. The heat expansion coefficient of the cubic boron nitride sintered material is preferably $4.0 \times 10^{-6}$/K or more and $6.0 \times 10^{-6}$/K or less, preferably $4.3 \times 10^{-6}$/K or more and $6.0 \times 10^{-6}$/K or less, preferably $4.5 \times 10^{-6}$/K or more and $6.0 \times 10^{-6}$/K or less, preferably $4.0 \times 10^{-6}$/K or more and $5.8 \times 10^{-6}$/K or less, preferably $4.3 \times 10^{-6}$/K or more and $5.8 \times 10^{-6}$/K or less, preferably $4.5 \times 10^{-6}$/K or more and $5.8 \times 10^{-6}$/K or less, preferably $4.0 \times 10^{-6}$/K or more and $5.5 \times 10^{-6}$/K or less, preferably $4.3 \times 10^{-6}$/K or more and $5.5 \times 10^{-6}$/K or less, and preferably $4.5 \times 10^{-6}$/K or more and $5.5 \times 10^{-6}$/K or less.

In the present specification, the heat expansion coefficient of the cubic boron nitride sintered material is measured with a commercially available measurement instrument (DIL 402C (TM) manufactured by NETZSCH Japan). The measurement temperature range is from 25°C to 500°C.

<Dislocation density>

The cubic boron nitride in the present embodiment preferably has a dislocation density of $1 \times 10^{16}/m^2$ or less. By having such a dislocation density, the cubic boron nitride sintered material has a higher heat conductivity.

The upper limit of the dislocation density of the cubic boron nitride is preferably $1 \times 10^{16}/m^2$ or less, more preferably $9 \times 10^{15}/m^2$ or less, and further preferably $8 \times 10^{15}/m^2$ or less. Although the lower limit of the dislocation density of the cubic boron nitride sintered material is not particularly limited, from a production viewpoint, it can be set to $1 \times 10^{15}/m^2$ or more. The dislocation density of the cubic boron nitride sintered material is preferably $1 \times 10^{15}/m^2$ or more and $1 \times 10^{16}/m^2$ or less, more preferably $1 \times 10^{15}/m^2$ or more and $9 \times 10^{15}/m^2$ or less, and further preferably $1 \times 10^{15}/m^2$ or more and $8 \times 10^{15}/m^2$ or less.

In the present specification, the dislocation density of the cubic boron nitride is calculated by the following procedure. A test piece composed of the cubic boron nitride sintered material is provided. In terms of size, the test piece has an observation surface of 2.0 mm × 2.0 mm and a thickness of 1.0 mm. The observation surface of the test piece is polished by a diamond grindstone.

X-ray diffraction measurement is performed on the observation surface of the test piece under the following conditions, and a line profile of a diffraction peak from each orientation plane of cubic boron nitride's major orientations which are (111), (200), (220), (311), (400) and (331) is obtained.

(X-ray diffraction measurement conditions)

X-ray source: synchrotron radiation
Condition for equipment: detector NaI (fluorescence is cut by an appropriate ROI)
Energy: 18 keV (wavelength: 0.6888 Å)
Spectroscopic crystal: Si (111)
Entrance slit: width 5 mm × height 0.5 mm
Light receiving slit: double slit (width 3 mm × height 0.5 mm)
Mirror: platinum coated mirror
Incident angle: 2.5 mrad
Scanning method: $2\theta$ - $\theta$ scan
Measurement peaks: six peaks from cubic boron nitride's (111), (200), (220), (311), (400), and (331). When it is difficult to obtain a profile depending on texture and orientation, the peak for that Miller index is excluded.
Measurement conditions: there are 9 or more measurement points set in the full width at half maximum. Peak top intensity is set to 2000 counts or more. Peak tail is also used in the analysis, and accordingly, the measurement range is set to about 10 times the full width at half maximum.

A line profile obtained from the above X-ray diffraction measurement will be a profile including both a true broadening attributed to a physical quantity such as the sample's inhomogeneous strain and a broadening attributed to the equipment. In order to determine inhomogeneous strain and crystallite size, a component attributed to the equipment is removed from the measured line profile to obtain a true line profile. The true line profile is obtained by fitting the obtained line profile and the line profile that is attributed to the equipment by a pseudo Voigt function, and subtracting the line profile attributed to the equipment. $LaB_6$ is used as a standard sample for removing a broadening of a diffracted peak attributed to the equipment. When significantly collimated radiation is used, a broadening of a diffracted peak attributed to the equipment may be regarded as zero.

The obtained true line profile is analyzed using the modified Williamson-Hall method and the modified Warren-Averbach method to calculate dislocation density. The modified Williamson-Hall method and the modified Warren-Averbach method are known line profile analysis methods used for determining dislocation density.

The modified Williamson-Hall method's expression is represented by the following expression (I).

[Expression 1]

[Expression 1]

$$\Delta K = \frac{0.9}{D} + \left(\frac{\pi M^2 b^2}{2}\right)^{1/2} \rho^{1/2} K C^{1/2} + O(K^2 C) \quad (I)$$

where $\Delta K$ represents a full width at half maximum of a line profile, D represents a crystallite size, M represents a dislocation arrangement parameter, b represents a Burgers vector, $\rho$ represents the dislocation density, K represents a scattering vector, O ($K^2C$) represents a higher-order term of $K^2C$, and C represents an average contrast factor.

C in the above expression (I) is represented by the following expression (II).

$$C = C_{h00}[1 - q(h^2k^2 + h^2l^2 + k^2l^2)/(h^2 + k^2 + l^2)^2] \quad (II)$$

In the above expression (II), a contrast factor $C_{h00}$ for screw dislocation and that for edge dislocation and a coefficient q for each contrast factor are obtained by using the computing code ANIZC, with a slip system of <1 10>{ 111}, and elastic stiffness $C_{11}$, $C_{12}$ and $C_{44}$ of 8.44 GPa, 1.9 GPa, and 4.83 GPa, respectively. Contrast factor $C_{h00}$ is 0.203 for screw dislocation and 0.212 for edge dislocation. The coefficient q for the contrast factor is 1.65 for screw dislocation and 0.58 for edge dislocation. Note that screw dislocation's ratio is fixed to 0.5 and edge dislocation's ratio is fixed to 0.5.

Furthermore, between dislocation and inhomogeneous strain, a relationship represented by an expression (III) is established using contrast factor C, as below:

$$\langle \varepsilon(L)^2 \rangle = (\rho C b^2/4\pi)\ln(R_e/L) \quad (III)$$

where $R_e$ represents dislocation's effective radius.

By the relationship of the above expression (III) and the Warren-Averbach expression, the following expression (IV) can be presented, and as the modified Warren-Averbach method, dislocation density $\rho$ and a crystallite size can be determined.

$$\ln A(L) = \ln A^S(L) - (\pi L^2 \rho b^2/2)\ln(R_e/L)(K^2C) + O(K^2C)^2 \quad (IV)$$

where A(L) represents a Fourier series, $A^S(L)$ represents a Fourier series for a crystallite size, and L represents a Fourier length.

For details of the modified Williamson-Hall method and the modified Warren-Averbach method, see T. Ungar and A. Borbely," The effect of dislocation contrast on x-ray line broadening: A new approach to line profile analysis," Appl. Phys. Lett., vol.69, no.21, p.3173, 1996, and T. Ungar, S. Ott, P. Sanders, A. Borbely, J. Weertman, "Dislocations, grain size and planar faults in nanostructured copper determined by high resolution X-ray diffraction and a new procedure of peak profile analysis," Acta Mater., vol.46, no.10, pp.3693-3699, 1998.

<Method for manufacturing cubic boron nitride sintered material>

The cubic boron nitride sintered material of the present embodiment can be produced by, for example, the following method.

«Raw material provision step»

A cubic boron nitride powder and a silicon powder are provided as raw materials. The cubic boron nitride content (purity) of the cubic boron nitride powder is preferably 99% or more. The cubic boron nitride powder preferably has an average particle size of 2 to 10 $\mu$m. The silicon powder preferably has a purity of 99% or more. The silicon powder preferably has an average particle size of 1 to 10 $\mu$m. In the present specification, the average particle size of the raw material powder means a median diameter d50 of a spherical equivalent diameter. The average particle size is measured with a particle size distribution measurement apparatus (trade name: MT3300EX) manufactured by MicrotracBEL Corp.

A graphite powder and/or a diamond powder can be provided for a carbon source. The graphite powder preferably has a purity of 99% or more. The graphite powder preferably has an average particle size of 1 to 10 $\mu$m. The diamond powder preferably has a purity of 99% or more. The diamond powder preferably has an average particle size of 2 to 10 $\mu$m.

An aluminum powder can be provided for an aluminum source. The aluminum powder preferably has a purity of 99% or more. The aluminum powder preferably has an average particle size of 10 to 100 $\mu$m.

<<Mixing step>>

A mixed powder is obtained by mixing the cubic boron nitride powder and the silicon powder. When the graphite powder and/or the aluminum powder are/is used, a mixed powder is obtained by mixing the cubic boron nitride powder and the silicon powder, and then adding the graphite powder and/or the aluminum powder. The mixing method is not particularly limited, and preferable mixing methods are, for example, ball mill mixing, bead mill mixing, planetary mill mixing, and jet mill mixing, from the viewpoint of efficient and homogeneous mixing. Each of such mixing methods may be a wet or dry method.

«Sintering step»

Next, the mixed powder is enclosed in a molybdenum capsule, the mixed powder is heated and pressurized to a temperature of 1600 to 2600°C and a pressure of 5 to 10 GPa by using a multi-anvil high pressure generator to obtain a cubic boron nitride sintered material.

The holding time at a temperature of 1600 to 2600°C and a pressure of 5 to 10 GPa as described above is preferably 10 minutes or more and 30 minutes or less. According to this, the dislocation density of the cubic boron nitride sintered material is lowered, and the size of cubic boron nitride particles is increased and the cubic boron nitride sintered material has higher heat conductivity.

[Second embodiment: heatsink]

A heatsink of the present embodiment is a heatsink using the above cubic boron nitride sintered material of the first embodiment. The heatsink of the present embodiment can have high heat conductivity and a heat expansion coefficient close to that of the power semiconductor. Therefore, the heatsink can inhibit heat conductivity from being decreased with use, and can allow for an increase in semiconductor life.

[Note 1]

It is preferable that the cubic boron nitride sintered material of the present disclosure consists of 90.0% by mass or more and 99.5% by mass or less of cubic boron nitride, 0.5% by mass or more and 10.0% by mass or less of silicon, and carbon, wherein

the cubic boron nitride sintered material has a total content of the cubic boron nitride and the silicon of 94.0% by mass or more and 100% by mass or less.

[Note 2]

It is preferable that the cubic boron nitride sintered material of the present disclosure consists of 90.0% by mass or more and 99.5% by mass or less of cubic boron nitride, 0.5% by mass or more and 10.0% by mass or less of silicon, and aluminum, wherein

the cubic boron nitride sintered material has a total content of the cubic boron nitride and the silicon of 94.0% by mass or more and 100% by mass or less.

[Note 3]

It is preferable that the cubic boron nitride sintered material of the present disclosure consists of 90.0% by mass or more and 99.5% by mass or less of cubic boron nitride, 0.5% by mass or more and 10.0% by mass or less of silicon, carbon, and aluminum, wherein

the cubic boron nitride sintered material has a total content of the cubic boron nitride and the silicon of 94.0% by mass or more and 100% by mass or less.

[Note 4]

It is preferable that the cubic boron nitride sintered material of the present disclosure consists of 90.0% by mass or more and 99.5% by mass or less of cubic boron nitride, 0.5% by mass or more and 10.0% by mass or less of silicon, and unavoidable impurities, wherein

the cubic boron nitride sintered material has a total content of the cubic boron nitride and the silicon of 94.0% by mass or more and 100% by mass or less.

[Note 5]

It is preferable that the cubic boron nitride sintered material of the present disclosure consists of 90.0% by mass or more and 99.5% by mass or less of cubic boron nitride, 0.5% by mass or more and 10.0% by mass or less of silicon, carbon, and unavoidable impurities, wherein
the cubic boron nitride sintered material has a total content of the cubic boron nitride and the silicon of 94.0% by mass or more and 100% by mass or less.

[Note 6]

It is preferable that the cubic boron nitride sintered material of the present disclosure consists of 90.0% by mass or more and 99.5% by mass or less of cubic boron nitride, 0.5% by mass or more and 10.0% by mass or less of silicon, aluminum, and unavoidable impurities, wherein
the cubic boron nitride sintered material has a total content of the cubic boron nitride and the silicon of 94.0% by mass or more and 100% by mass or less.

[Note 7]

It is preferable that the cubic boron nitride sintered material of the present disclosure consists of 90.0% by mass or more and 99.5% by mass or less of cubic boron nitride, 0.5% by mass or more and 10.0% by mass or less of silicon, carbon, aluminum, and unavoidable impurities, wherein
the cubic boron nitride sintered material has a total content of the cubic boron nitride and the silicon of 94.0% by mass or more and 100% by mass or less. Examples

The embodiments will now be described more specifically by way of Examples. However, the present invention is not limited to these Examples.

[Production of cubic boron nitride sintered material]

«Raw material provision step»

A cubic boron nitride powder (abbreviated as "cBN Powder" in Table 1.), a silicon powder, a graphite powder (abbreviated as "Gr powder" in Table 1.), a diamond powder, and an aluminum powder (abbreviated as "Al Powder" in Table 1.) were provided as raw materials of a cubic boron nitride sintered material of each Sample. The graphite powder, the diamond powder and the aluminum powder were used for any Sample with the description "Yes" in the "Gr powder", the "diamond powder" and the "Al powder" in the "raw material provision step" in Table 1.

The cubic boron nitride powder has a purity of 99%. The average particle size of the cubic boron nitride powder used in each Sample is as shown in the "d50 (μm)" column of the "cBN powder" of the "raw material provision step" in Table 1. The silicon powder has a purity of 99.9% and an average particle size of 5 μm. The graphite powder has a purity of 99.9% and an average particle size of 1 μm. The diamond powder has a purity of 99% and an average particle size of 2 μm. The aluminum powder has a purity of 99.5% and an average particle size of 30 μm.

<<Mixing step>>

A mixed powder was obtained by mixing the cubic boron nitride powder and the silicon powder. The mixing ratio between the cubic boron nitride powder and the silicon powder was adjusted so that the cubic boron nitride content and the silicon content in each cubic boron nitride sintered material produced were values respectively shown in the "cBN content" and "Si content" columns of the "cubic boron nitride sintered material" in Table 2. The mixing method was made with a ball mill.

Subsequently, when at least any of the graphite powder, the diamond powder and the aluminum powder was used, at least any of the graphite powder, the diamond powder and the aluminum powder was further added to the mixed powder, and thus a mixed powder was obtained. The amounts of the graphite powder, the diamond powder and the aluminum powder added were adjusted so that the carbon content and the aluminum content in each cubic boron nitride sintered material produced were values respectively shown in the "C content" and "Al content" columns of the "cubic boron nitride sintered material" in Table 2. The mixing method was made with a ball mill.

«Sintering step»

Next, the mixed powder was enclosed in a molybdenum capsule, the mixed powder was heated and pressurized by using a six-way multi-anvil high pressure generator, and a cubic boron nitride sintered material of each Sample was obtained. The heating and pressurizing was performed at multiple stages: the "first stage", "second stage" and "third stage" as shown in the "sintering step" in Table 1. The designation "-" in the "third stage" columns in Table 1 shows no heating and pressurizing performed at the relevant stage. The holding time at the final stage is shown in the "holding time at final stage" column in Table 1. The "holding time at final stage" here means the holding time at a pressure and a temperature finally attained in the sintering step.

For example, Sample 1 was heated and pressurized to a temperature of 25°C and a pressure of 10 GPa at the first stage, heated and pressurized to a temperature of 1600°C and a pressure of 5.5 GPa at the second stage, and held at the temperature (1600°C) and the pressure (5.5 GPa) attained at the second stage, for 20 minutes.

[Table 1]

Table 1

| Sample No. | Raw material provision step | | | | Sintering step | | | | | | |
|---|---|---|---|---|---|---|---|---|---|---|---|
| | cBN powder | Gr powder | Diamond powder | Al powder | First stage | | Second stage | | Third stage | | Holding time at final stage |
| | | | | | Temperature | Pressure | Temperature | Pressure | Temperature | Pressure | |
| | d50 (μm) | Yes/No | Yes/No | Yes/No | °C | GPa | °C | GPa | °C | GPa | minutes |
| 1 | 10 | No | No | No | 25 | 10 | 1600 | 5.5 | - | - | 20 |
| 2 | 2 | No | No | No | 25 | 10 | 2000 | 10 | - | - | 20 |
| 3 | 2 | No | No | No | 25 | 10 | 2000 | 10 | - | - | 20 |
| 4 | 5 | No | No | No | 1000 | 0 | 1000 | 10 | 2600 | 10 | 20 |
| 5 | 8 | Yes | No | No | 25 | 10 | 2000 | 10 | - | - | 20 |
| 6 | 2 | Yes | No | No | 25 | 10 | 2000 | 10 | - | - | 20 |
| 7 | 2 | No | No | Yes | 25 | 10 | 2000 | 10 | - | - | 20 |
| 8 | 2 | Yes | No | Yes | 25 | 10 | 2000 | 10 | - | - | 20 |
| 9 | 2 | Yes | No | Yes | 25 | 10 | 2000 | 10 | - | - | 20 |
| 10 | 10 | No | No | No | 25 | 10 | 2000 | 10 | - | - | 20 |
| 11 | 2 | No | No | No | 25 | 10 | 2000 | 10 | - | - | 20 |
| 12 | 2 | Yes | No | Yes | 25 | 10 | 2000 | 10 | - | - | 20 |
| 13 | 2 | Yes | No | Yes | 25 | 10 | 2000 | 10 | - | - | 20 |
| 14 | 2 | No | Yes | No | 25 | 10 | 2000 | 10 | - | - | 20 |
| 15 | 2 | No | No | No | 25 | 10 | 2000 | 10 | - | - | 20 |
| 16 | 2 | Yes | No | Yes | 25 | 10 | 2000 | 10 | - | - | 20 |

[Measurement]

The polycrystalline cubic boron nitride as each Sample was subjected to measurement of the cubic boron nitride content, the silicon content, the carbon content, the aluminum content, and the heat conductivity of the cubic boron nitride sintered material, the dislocation density and the heat expansion coefficient of cubic boron nitride, the d50 and d90 of equivalent circle diameters of crystal grains composed of cubic boron nitride, and the transverse rupture strength.

<Cubic boron nitride content>

The cubic boron nitride content (% by mass) in the cubic boron nitride sintered material as each Sample was measured. The specific measurement method is as shown in the first embodiment. The results are shown in the "cBN content" column of the "cubic boron nitride sintered material" in Table 2.

<Silicon content, carbon content and aluminum content>

The cubic boron nitride sintered material as each Sample was subjected to measurement of the silicon content, the carbon content and the aluminum content therein. The specific measurement methods are as shown in the first embodiment. The results are shown in the "Si content", "C content" and "Al content" columns of the "cubic boron nitride sintered material" in Table 2.

<Heat conductivity>

The heat conductivity of the cubic boron nitride sintered material as each Sample was measured. The specific measurement method is as shown in the first embodiment. The results are shown in the "heat conductivity" column of the "cubic boron nitride sintered material" in Table 2. In the present specification, when the heat conductivity of the cubic boron nitride sintered material is 290 W/mK or more, it is determined that the cubic boron nitride sintered material has high heat conductivity.

<Dislocation density>

The dislocation density of the cubic boron nitride of the cubic boron nitride sintered material as each Sample was measured. The specific measurement method is as shown in the first embodiment. The results are shown in the "dislocation density" column of the "cubic boron nitride sintered material" in Table 2.

<Heat expansion coefficient>

The heat expansion coefficient of the cubic boron nitride sintered material as each Sample was measured. The specific measurement method is as shown in the first embodiment. The results are shown in the "heat expansion coefficient" column of the "cubic boron nitride sintered material" in Table 2. In the present specification, when the heat expansion coefficient of the cubic boron nitride sintered material is in the range of the heat expansion coefficient (4.0 to $6.0 \times 10^{-6}$/K) of the power semiconductor, it is determined that the heat expansion coefficient of the cubic boron nitride sintered material is close to the heat expansion coefficient of the power semiconductor.

<d50 and d90 of equivalent circle diameters of crystal grains>

The d50 and d90 of equivalent circle diameters of a plurality of crystal grains composed of cubic boron nitride included in the cubic boron nitride sintered material as each Sample were measured. The specific measurement methods are as shown in the first embodiment. The results are shown in the "d50" and "d90" columns of the "crystal grains (cBN particles)" of the "cubic boron nitride sintered material" in Table 2.

[Table 2]

| Sample No. | Cubic boron nitride sintered material | | | | | | | | |
|---|---|---|---|---|---|---|---|---|---|
| | Crystal grains (cBN particles) | | Heat conductivity | Dislocation density | cBN content | Si conten t | C conten t | Al conten t | Heat expansion coefficient |
| | d50 | d90 | | | | | | | |
| | μm | μm | W/mK | $\times 10^{15}/m^2$ | % by mass | % by mass | % by mass | % by mass | $10^{-6}$/K |
| 1 | 10. 0 | 13. 0 | 600 | 9.0 | 95.00 | 5.00 | 0 | 0 | 5.0 |
| 2 | 2.0 | 2.7 | 310 | 7.1 | 90.50 | 9.50 | 0 | 0 | 5.8 |
| 3 | 2.0 | 2.7 | 280 | 7.1 | 89.00 | 11.00 | 0 | 0 | 6.1 |
| 4 | 5.0 | 6.5 | 470 | 3.8 | 95.00 | 5.00 | 0 | 0 | 5.1 |
| 5 | 8.0 | 11. 0 | 580 | 6.9 | 98.00 | 1.10 | 0.90 | 0 | 4.3 |
| 6 | 2.0 | 2.7 | 290 | 7.0 | 93.00 | 1.70 | 5.30 | 0 | 4.8 |
| 7 | 2.0 | 2.7 | 305 | 7.0 | 95.00 | 2.00 | 0 | 3.00 | 4.5 |
| 8 | 2.0 | 2.7 | 310 | 7.0 | 90.00 | 4.00 | 5.00 | 1.00 | 4.8 |
| 9 | 2.0 | 2.7 | 310 | 7.0 | 90.00 | 5.00 | 0 | 5.00 | 5.3 |
| 10 | 10. 0 | 13. 0 | 650 | 8.4 | 99.50 | 0.50 | 0 | 0 | 4.1 |
| 11 | 10. 0 | 13. 0 | 650 | 8.4 | 99.60 | 0.40 | 0 | 0 | 3.9 |
| 12 | 2.0 | 2.7 | 285 | 7.4 | 89.89 | 10.00 | 0.10 | 0.01 | 6.0 |
| 13 | 2.0 | 2.7 | 250 | 7.4 | 85.00 | 5.00 | 5.00 | 5.00 | 5.8 |
| 14 | 2.0 | 2.7 | 320 | 7.4 | 90.00 | 5.00 | 5.00 | 0 | 5.0 |
| 15 | 2.0 | 2.7 | 302 | 6.8 | 90.00 | 10.00 | 0 | 0 | 5.8 |
| 16 | 2.0 | 2.7 | 303 | 6.8 | 90.00 | 9.89 | 0.10 | 0.01 | 5.9 |

[Consideration]

The cubic boron nitride sintered material of each of Sample 1, Sample 2, Sample 4 to Sample 10, and Sample 14 to Sample 16 corresponds to the Example. It was confirmed that these cubic boron nitride sintered materials all had a heat conductivity of 290 W/mK or more, had a high heat conductivity, and a heat expansion coefficient of 4.1 to 5.8 × $10^{-6}$/K, and the heat expansion coefficient was close to the heat expansion coefficient of the power semiconductor.

The cubic boron nitride sintered material of Sample 3 corresponds to the Comparative Example. The cubic boron nitride sintered material of Sample 3 had lower heat conductivity than the cubic boron nitride sintered material corresponding to the Example. It is presumed that this is because the silicon content is as high as 11.00% by mass and thus the silicon and the silicon compound (SiN and/or the like) are much present between cubic boron nitride particles and the bonding force between cBN particles is lowered.

The cubic boron nitride sintered material of Sample 11 corresponds to the Comparative Example. The cubic boron nitride sintered material of Sample 11 was lower in heat expansion coefficient than the heat expansion coefficient of the power semiconductor. It is presumed that this is because the silicon content is as low as 0.40% by mass.

The cubic boron nitride sintered material of each of Sample 12 and Sample 13 corresponds to the Comparative Example. The cubic boron nitride sintered material of each of Sample 12 and Sample 13 had lower heat conductivity than the cubic boron nitride sintered material corresponding to the Example. It is presumed that this is because the cBN content is as low as less than 90%.

Although embodiments and Examples of the present disclosure have been described above, from the beginning it has been planned that various configurations of the above-described embodiments and Examples may be appropriately combined and variously modified.

The embodiments and Examples disclosed this time are to be considered as illustrative in all points and are not restrictive. The scope of the present disclosure is shown not by the embodiments and examples described above but by the claims, and it is intended meanings equivalent to the claims and all modifications are also included within the scope of the present disclosure.

## Claims

1. A cubic boron nitride sintered material comprising 90.0% by mass or more and 99.5% by mass or less of cubic boron nitride and 0.5% by mass or more and 10.0% by mass or less of silicon, wherein
the cubic boron nitride sintered material has a total content of the cubic boron nitride and the silicon of 94.0% by mass or more and 100% by mass or less.

2. The cubic boron nitride sintered material according to claim 1, wherein
the cubic boron nitride sintered material comprises carbon, and has a carbon content of 0.10% by mass or more and 5.00% by mass or less.

3. The cubic boron nitride sintered material according to claim 2, wherein
at least a portion of the carbon is diamond.

4. The cubic boron nitride sintered material according to any one of claims 1 to 3, wherein
the cubic boron nitride sintered material comprises aluminum, and has an aluminum content of 0.01% by mass or more and 5.00% by mass or less.

5. The cubic boron nitride sintered material according to any one of claims 1 to 4, wherein

   the cubic boron nitride sintered material comprises a plurality of crystal grains composed of cubic boron nitride, and
   the crystal grains have a median diameter d50 of an equivalent circle diameter of 1.0 μm or more.

6. The cubic boron nitride sintered material according to any one of claims 1 to 5, wherein the cubic boron nitride sintered material has a heat conductivity of 300 W/mK or more.

7. The cubic boron nitride sintered material according to any one of claims 1 to 6, wherein the cubic boron nitride sintered material has a heat expansion coefficient of $4.0 \times 10^{-6}$/K or more and $6.0 \times 10^{-6}$/K or less.

8. The cubic boron nitride sintered material according to any one of claims 1 to 7, wherein the cubic boron nitride has a dislocation density of $1 \times 10^{16}/m^2$ or less.

9. The cubic boron nitride sintered material according to claim 8, wherein the dislocation density is calculated by using a modified Williamson-Hall method and a modified Warren-Averbach method.

10. The cubic boron nitride sintered material according to claim 8 or 9,
wherein the dislocation density is measured using synchrotron radiation as an X-ray source.

11. A heatsink using the cubic boron nitride sintered material according to any one of claims 1 to 10.

## INTERNATIONAL SEARCH REPORT

International application No. PCT/JP2021/028575

A. CLASSIFICATION OF SUBJECT MATTER
Int.Cl. H01L23/373(2006.01)i, C04B35/5835(2006.01)i
FI: C04B35/5835, H01L23/36M

According to International Patent Classification (IPC) or to both national classification and IPC

B. FIELDS SEARCHED

Minimum documentation searched (classification system followed by classification symbols)
Int.Cl. H01L23/373, C04B35/5835

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | CN 109748596 A (HENAN HAINAIDE NEW MATERIAL CO., LTD.) 14 May 2019 (2019-05-14), example 1 | 1, 4-11<br>2-3 |
| Y | WO 2019/039037 A1 (SUMITOMO ELECTRIC INDUSTRIES, LTD.) 28 February 2019 (2019-02-28), paragraph [0017] | 2-3 |
| A | CN 109574679 A (HENAN HAINAIDE NEW MATERIAL CO., LTD.) 05 April 2019 (2019-04-05), entire text | 1-11 |

☐ Further documents are listed in the continuation of Box C.  ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 09 September 2021 | 21 September 2021 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2021/028575

| | | |
|---|---|---|
| CN 109748596 A | 14 May 2019 | (Family: none) |
| WO 2019/039037 A1 | 28 February 2019 | US 2020/0102252 A1<br>paragraph [0022]<br>EP 3674429 A1<br>CN 110785504 A<br>KR 10-2020-0045462 A |
| CN 109574679 A | 05 April 2019 | (Family: none) |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **T. UNGAR ; A. BORBELY.** The effect of dislocation contrast on x-ray line broadening: A new approach to line profile analysis. *Appl. Phys. Lett.,* 1996, vol. 69 (21), 3173
- **T. UNGAR ; S. OTT ; P. SANDERS ; A. BORBELY ; J. WEERTMAN.** Dislocations, grain size and planar faults in nanostructured copper determined by high resolution X-ray diffraction and a new procedure of peak profile analysis. *Acta Mater.,* 1998, vol. 46 (10), 3693-3699